# EUROPEAN PATENT SPECIFICATION

(11) **EP 0 295 036 B1**
(45) Date of publication and mention of the grant of the patent: **09.03.1994**
(21) Application number: 88305157.5
(22) Date of filing: 07.06.1988
(51) Int. Cl.: G11C 14/00

(54) **Semiconductor memory device**
Halbleiterspeicheranordnung
Dispositif de mémoire à semi-conducteurs

(30) Priority: 08.06.1987 JP 141443/87
(43) Date of publication of application: 14.12.1988
(73) Proprietor: FUJITSU LIMITED, Kawasaki-shi, Kanagawa 211 (JP)
(72) Inventor: Arakawa, Hideki, Yokohama-shi Kanagawa 241 (JP)
(74) Representative: Billington, Lawrence Emlyn

(56) References cited:
- EP-A- 0 182 595
- EP-A- 0 200 480
- EP-A- 0 204 385

## Description

The present invention relates to a semiconductor memory device and, more particularly, to a memory device in the form of a non-volatile random access memory (NVRAM), in which a volatile memory cell, for example, a static RAM(SRAM) cell or dynamic RAM(DRAM) cell, and a non-volatile memory cell using a floating gate circuit element, for example, an electrically erasable and programmable read only memory (EEPROM) cell, are combined on a one-to-one basis on a chip.

Since an NVRAM possesses both a function of an SRAM, i.e., a high speed read/write operation, and a feature of an EEPROM, i.e., non-volatility, it has been utilized in fields in which, even when a power source is OFF, data is not lost but stored, and when the power source is ON, the data can be freely erased and reprogrammed.

In the above NVRAM, when the power source is ON, the SRAM carries out a read/write operation in the same way as a conventional SRAM, the data in the SRAM is stored in the EEPROM before the power source is turned OFF, and utilizing the non-volatile characteristic, the data is held therein while the power source is OFF. When the power source is again switched ON, the data in the EEPROM is recalled to the SRAM and the conventional read/write operation carried out. Accordingly, to realize such store and recall operations, a structure of each of the memory cell units including the SRAM cell and EEPROM cell is complicated, and therefore, a space occupied by the cells on the chip is increased; which leads to a lower reliability and degree of integration of the memory device. Therefore, an improvement by an appropriate design of the cell structure is required.

The store operation in the NVRAM is carried out by utilizing a tunnel effect occurring within an oxidation layer formed between a floating gate and a diffused region in the EEPROM cell. In the store operation, a strongly boosted voltage is employed and a portion thereof is applied across a tunnel capacitor representing an equivalent capacitance of the oxidation layer, with the result that positive or negative charges remain on the floating gate. Note, the positive charges correspond to "1" data and the negative charges to "0".

In the known EEPROM cell, several capacitors other than the tunnel capacitor are parasitically formed in a series connection with the tunnel capacitor, which will be described later. Accordingly, when the strongly boosted voltage for storing data into the EEPROM cells is applied to each of the cells, one portion of the voltage is applied across the tunnel capacitor and the other portion thereof is applied across the parasitically formed capacitors. Namely, to carry out the store operation, a voltage higher than a voltage necessary for electrifying the floating gate to store data must be prepared as the strongly boosted voltage.

Therefore, when the non-volatile memory cells including floating gate circuit elements are integrated on a substrate, a region for cutting a channel must be made large or a potential barrier at the junction between the diffused region in the substrate and the gate must be made high, so that each element can withstand the application of the strongly boosted voltage. This, however, is detrimental to a high degree of integration and thus not preferable.

Also, when any one of the tunnel capacitor and other parasitically formed capacitors is destroyed, the whole boosted voltage is lowered, and accordingly, a sufficient voltage necessary for storing data cannot be obtained.

It is therefore desirable to provide a semiconductor memory device in which the number of capacitors formed in a non-volatile memory cell portion is decreased to reduce the space occupied by memory cells on a chip and, accordingly, raise the degree of integration of the circuit.

EP-A-0 204 385 discloses a semiconductor memory device according to the preamble of accompanying claim 1.

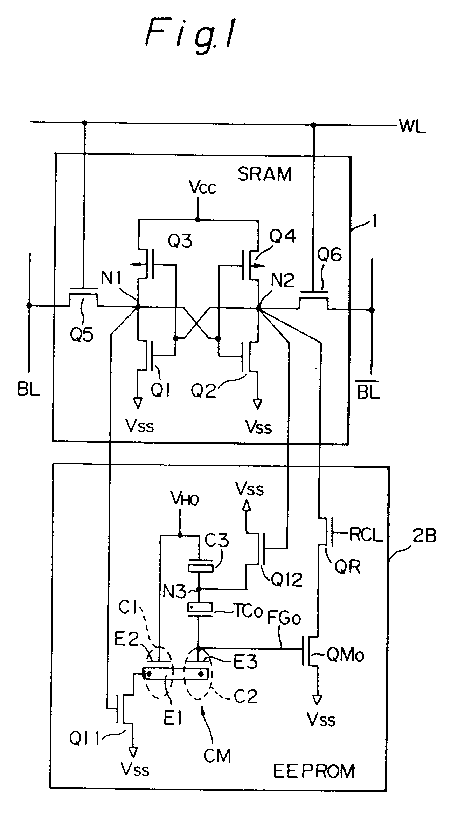

EP-A-0 200 480 by the present applicant generally corresponds to the prior art discussed below with reference to Fig. 1, except that the non-volatile memory cell portion uses a recall capacitor rather than a recall transistor.

EP-A-0 182 595 discloses a NVRAM in which the two branches of the flip-flop are supplied by separate power sources which are sequentially turned on during a restore operation, thereby avoiding the need for unbalancing the cell.

According to the present invention, there is provided a semiconductor memory device including a memory cell array having a memory cell at each intersection between a plurality of word lanes and bit lines, the memory cell including:-
a volatile memory cell portion having a flip-flop arrangement and carrying out a read/write operation of data between a pair of nodes and a pair of bit lines; wherein, when a predetermined high voltage higher than a normal power voltage is applied to the flip-flop arrangement, a difference voltage appearing between the pair of nodes substantially becomes the high voltage;
and a non-volatile memory cell portion provided for the volatile memory cell portion on a one-to-one basis, including a memory transistor having a floating gate, and a capacitor circuit operatively connected between the pair of nodes in the volatile memory cell portion, the capacitor circuit having a capacitor and a tunnel capacitor connected to said floating gate, said tunnel capacitor undergoing a tunnel effect when said high voltage is applied;
wherein based on the application of the high voltage or a control signal, a storing operation of storing data from the volatile memory cell portion to the non-volatile memory cell portion or a recall operation of recalling the data from the non-volatile memory cell portion to the volatile memory cell portion is carried out;
characterised in that, in the non-volatile memory cell portion, the floating gate of the memory transistor is interposed between the capacitor and tunnel capacitor, and a switching transistor is connected between the memory transistor and one of the pair of nodes and is turned ON in response to said control signal in said recall operation,
and in that a bit line load control circuit is operatively connected to one of the pair of bit lines corresponding to the other of the pair of nodes and operable to forcibly lower the potential of said bit line in said recall operation.

Reference is made, by way of example, to the accompanying drawings, in which:-
Fig. 1 is a circuit diagram illustrating a constitution of a memory cell employed in an example of a previous NVRAM device;
Fig. 2 is a block diagram schematically showing a constitution of the NVRAM device as an embodiment of the present invention;
Fig. 3 is a circuit diagram illustrating a constitution of the memory cell shown in Fig. 2;
Fig. 4 is a sectional view showing an example of the capacitor circuit shown in Fig. 3;
Fig. 5 is a circuit diagram illustrating a constitution of the high voltage generating circuit shown in Figs. 2 and 3;
Figs. 6a to 6g are waveform diagrams for explaining a store operation of the device shown in Fig. 3;
Figs. 7a and 7b are views showing the states of a memory in the EEPROM cell in the store operation;
Figs. 8a to 8f are waveform diagrams for explaining a recall operation of the device shown in Fig. 3; and
Fig. 9 is a circuit diagram illustrating a modification of the embodiment shown in Fig. 3.

For a better understanding of the preferred embodiments, the problems of a previous NVRAM device will now be explained with reference to Fig. 1.

Note, in the following description, the term "transistor" indicates an enhancement type N-channel metal oxide semiconductor (NMOS) field effect transistor, and thus a special definition thereof is not added thereto.

Figure 1 shows a circuit constitution of a memory cell employed in an example of a previous NVRAM device. The memory cell includes a volatile memory cell portion 1, i.e., an SRAM in the illustrated example, and a non-volatile memory cell portion 2B, i.e., an EEPROM in the illustrated example.

The volatile memory cell portion 1 includes a flip-flop type arrangement having transistors Q1 ∼ Q4 as in a conventional SRAM device. A read/write operation of data is carried out between nodes N1, N2 and the corresponding bit lines BL, BL through transfer gate transistors Q5, Q6.

The non-volatile memory cell portion 2B includes transistors Q11, Q12, a transistor QR turning ON in response to a control signal RCL in a recall operation, a memory transistor QM₀ in which a gate FG₀ is brought to a floating state, a capacitor module CM, a capacitor C3, and a tunnel capacitor TC₀ as a floating gate circuit element. In the capacitor module CM, capacitors C1 and C2 are formed between an electrode E1 and electrodes E2 and E3, respectively. The electrode E1 corresponds to a diffused region constituting a source/drain (S/D) in the semiconductor substrate, and the electrodes E2 and E3 correspond to gates. Also, a capacitance of the tunnel capacitor TC₀ is made smaller than that of any one of the capacitors C1, C2 and C3, taking the store operation into consideration.

Next, the store and recall operation of the device shown in Fig. 1 will be described.

### A. Store Operation

Assuming that the node N1 is at "L" level and the node N2 is at "H" level, when a power supply voltage VH₀ is raised to 25 ∼ 30 V, the transistor Q11 is brought to the OFF state and the transistor Q12 is brought to the ON state. Accordingly, the node N3 is lowered to "L" level, i.e., substantially a potential of V_{SS} , and the power supply voltage VH₀ is applied to a series circuit of the capacitor C1, C2 and TC₀. As previously described, since the capacitance of the capacitors C1 and C2 is greater than that of the capacitor TC₀ , a greater portion of the voltage VH₀ is applied across the tunnel capacitor TC₀. As a result, electrons are injected from the node N3 to the gate FG₀ due to the tunnel effect, and accordingly, negative charges are accumulated in the floating gate circuit of the memory transistor QM₀.

Likewise, where the node N1 is at "H" level and the node N2 is at "L" level, positive charges are accumulated in the gate FG₀.

### B. Recall Operation

First, the potentials at bit lines BL and B̅L̅ are settled or preset to the predetermined levels and a potential at a word line WL is raised to "H" level. Accordingly, the transistors Q5 and Q6 are turned ON and the nodes N1 and N2 settle to predetermined levels in accordance with the potentials at the bit lines BL and B̅L̅. Assuming that the node N1 is "L" level and the node N2 is "H" level, the control signal RCL is raised to "H" level. If negative charges are accumulated in the gate FG₀ , the transistor QM₀ is turned OFF and a source of the transistor QR is electrically separated from a lower power supply line V_{SS}. Accordingly, a potential at the node N2 is maintained "H" level. Conversely, a potential at the node N1 is maintained "L" level, and as a result, the flip-flop circuit is preset.

Likewise, if positive charges are accumulated in the gate FG₀ , the transistors QM₀ and QR are turned ON, and accordingly, the node N2 is pulled down to "L" level and the node N1 is pulled up to "H" level.

According to the constitution of the non-volatile memory cell portion 2B shown in Fig. 1, the voltage across the tunnel capacitor TC₀ , normally 12 ∼ 15 V, is fed by dividing the power supply voltage VH₀ , normally 25 ∼ 30 V, in accordance with the ratio of each capacitance of the capacitors C1, C2, and C3. Namely, although the voltage necessary for storing data is 12 ∼ 15 V at highest, to obtain this voltage, a power supply voltage VH₀ (25 ∼ 30 V) higher than that voltage (12 ∼ 15 V) must be prepared.

Therefore, the non-volatile memory cell portion must be formed in a relatively large size on a chip so that it withstand the application of the high voltage VH₀. This means that a degree of integration is lowered, and thus is not preferable.

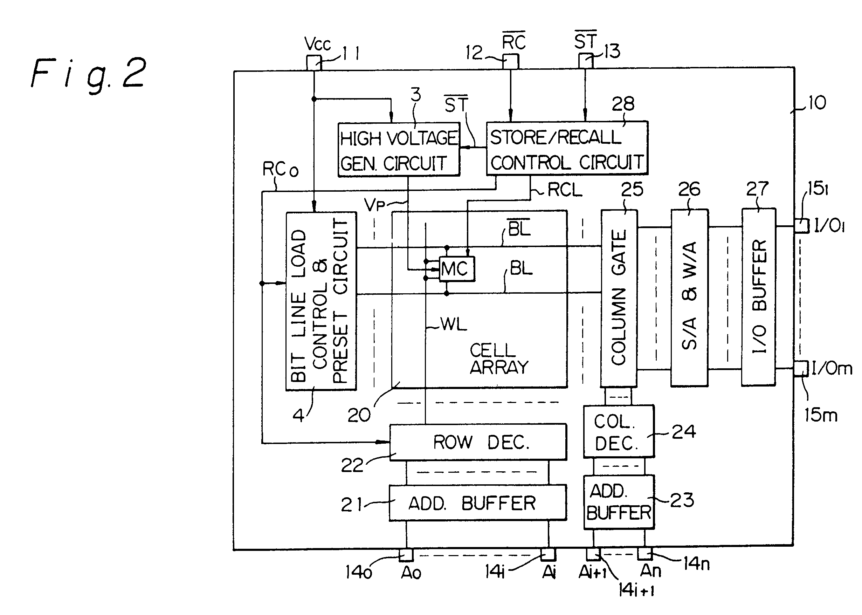

A preferred embodiment of the present invention will now be described in detail with reference to Figs. 2 to 8f.

Figure 2 schematically illustrates a constitution of the NVRAM device as an embodiment of the present invention.

In Fig. 2, 10 denotes an NVRAM device in the form of a chip; 11 a pin terminal for receiving a higher power supply voltage V_{CC} (5 V); 12 a pin terminal for receiving a signal R̅C̅ for controlling a recall operation; 13 a pin terminal for receiving a signal S̅T̅ for controlling a store operation; 14₀ ∼ 14ᵢ pin terminals for receiving row address signals A₀ ∼ Aᵢ; 14ᵢ₊₁ ∼ 14ₙ pin terminals for receiving column address signals Aᵢ₊₁ ∼ Aₙ; and 15ₗ ∼ 15ₘ pin terminals for transmitting input/output (I/O) signals I/Oₗ ∼ I/Oₘ.

Reference 20 denotes a memory cell array having a memory cell MC provided at each intersection between a plurality of word lines WL and a plurality of pairs of bit lines BL and B̅L̅. A concrete constitution of the memory cell MC will be described later. Reference 21 denotes an address buffer for buffering the row address signals A₀ ∼ Aᵢ input through the pin terminals 14₀ ∼ 14ᵢ: 22 denotes a row decoder, which selects one of the word lines WL based on the row address designation in the read/write operation and selects all of the word lines WL in response to a recall control signal RC₀ in the recall operation; 23 denotes an address buffer for buffering the column address signals Aᵢ₊₁ ∼ Aₙ input through the pin terminals 14ᵢ₊₁ ∼ 14ₙ: 24 denotes a column decoder for selecting one of the pairs of bit lines BL and B̅L̅ based on the column address designation in the read/write operation; 25 denotes a column gate for passing data on the pair of bit lines selected by the column decoder 24; 26 denotes a sense amplifying (S/A) and write amplifying (W/A) circuit for amplifying the read-out data or input data; and 27 denotes an I/O buffer for buffering the read-out data or input data.

Reference 28 denotes a store/recall control circuit, which outputs the recall control signal RC₀ and then a recall signal RCL in response to the signal R̅C̅ input through the pin terminal 12, and outputs a low active store signal S̅T̅ in response to the signal S̅T̅ input through the pin terminal 13. Reference 3 denotes a high voltage generating circuit, which receives the power supply voltage V_{CC} input through the pin terminal 11 and generates a variable high voltage V_{P} in response to the store signal ST. The high voltage V_{P} has a value of V_{CC} (5 V) necessary for the read/write operation or a value of V_{HH} (18 ∼ 22 V) necessary for the store operation. A concrete constitution and operation of the high voltage generating circuit 3 will be described later. Reference 4 denotes a bit line load control and preset circuit, which receives the power supply voltage V_{CC} , functions as a bit line load, and presets a potential at each of the bit lines BL and B̅L̅ to a predetermined level in response to the recall control signal RC₀ prior to the recall operation.

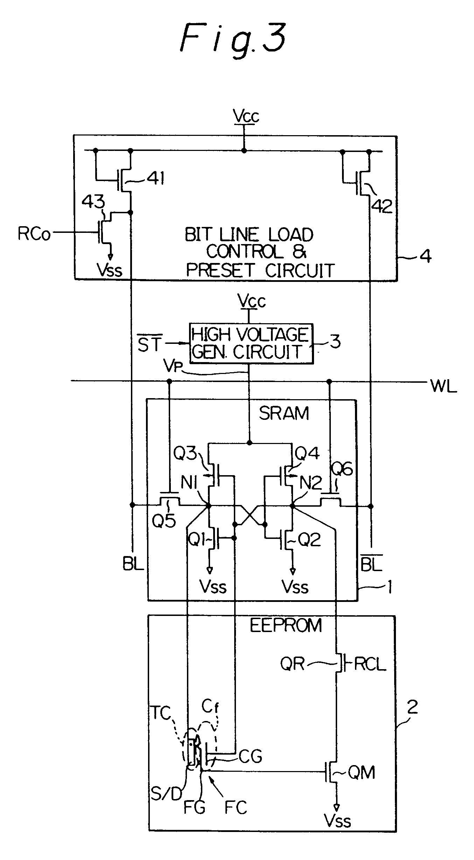

Next, a circuit constitution of the memory cell MC shown in Fig. 2 will be described in detail with reference to Fig. 3.

The memory cell consists of a volatile memory cell portion 1, i.e., an SRAM, and a non-volatile memory cell portion 2, i.e., an EEPROM. The volatile memory cell portion 1 is operatively connected to the high voltage generating circuit 3 and the bit line load control and preset circuit 4.

The volatile memory cell portion 1 is constituted by a flip-flop type arrangement as in a conventional SRAM device, i.e., an SRAM cell having two N-channel transistors Q1 and Q2 and two P-channel transistors Q3 and Q4, and two transfer gate transistors Q5 and Q6 connected between the nodes N1 and N2 of the cell and the bit lines BL and B̅L̅, respectively. The volatile memory cell portion 1 carries out a read/write operation of data between the nodes N1 and N2 and the corresponding bit lines BL and BL through the transfer gates Q5, Q6.

The non-volatile memory cell portion 2 includes a recall transistor QR, a memory transistor QM, and a capacitor circuit FC. The capacitor circuit FC and the memory transistor QM constitute a non-volatile memory cell, i.e., an EEPROM cell.

The capacitor circuit FC is composed of the diffused region S/D constituting a source/drain (S/D) in the semiconductor substrate, a floating gate FG formed via a tunnel insulation film (not shown in Fig. 3) on the diffused region S/D, and a control gate CG formed via an insulation film (not shown in Fig. 3) on the gate FG. A tunnel capacitor TC is formed between the diffused region S/D and the floating gate FG, and a capacitor C_{f} , corresponding to the capacitor C2 shown in the device of Fig. 1, is formed between the floating gate and the control gate CG. The diffused region S/D and control gate CG are connected to the nodes N1 and N2, respectively, in the volatile memory cell portion 1, and the floating gate FG is connected to a gate of the memory transistor QM. A source of the memory transistor QM is connected to a lower power supply line V_{SS} (0 V), and a drain thereof is connected via the recall transistor QR to the node N2 in the volatile memory cell portion 1. The recall transistor QR is employed when data stored in the non-volatile memory cell portion 2 is recalled to the volatile memory cell portion 1, i.e., when the power source is turned ON, and turned ON in response to the "H" level recall signal RCL.

On the other hand, the bit line load control and preset circuit 4 includes a transistor 41 as a load of the bit line BL, a transistor 42 as a load of the complementary bit line BL, and a transistor 43 for pulling a potential at the bit line BL down to the level of V_{SS} (0 V) in response to the "H" level recall control signal RC₀.

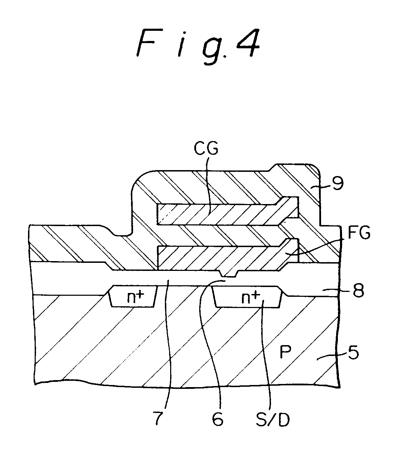

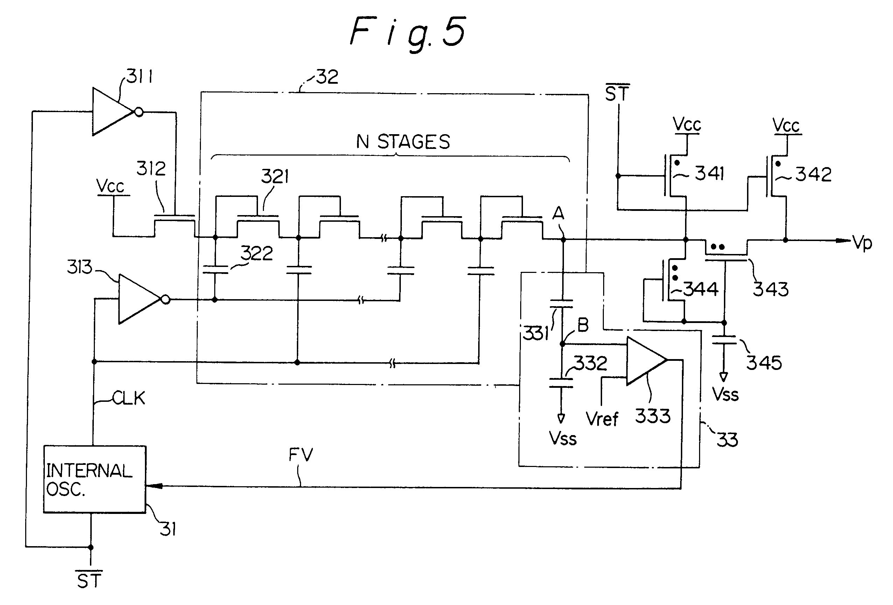

Figure 4 shows a section of an example of the capacitor circuit FC shown in Fig. 3. In Fig. 4, 5 denotes a P type semiconductor substrate; 6 a tunnel oxidation film of SiO₂ having a thickness of approximately 100 Å (10 nm); 7 a gate oxidation film of SiO₂ used for the memory transistor QM (not shown in Fig. 4); 8 a field oxidation film of SiO₂; and 9 an insulation layer for insulating the control gate CG from the floating gate FG. The thickness between the gates FG and CG is selected to be approximately 500 to 600 Å (50 to 60 nm). In Fig. 4, the tunnel capacitor TC (see Fig. 3) is formed between the floating gate FG and the diffused region S/D, and the capacitor C_{f} (see Fig. 3) is formed between the gate FG and the control gate CG.

According to the constitution of the memory cell shown in Fig. 3, the voltage necessary for storing data, i.e., the voltage (normally 12 ∼ 15 V) across the tunnel capacitor TC, is fed by dividing the voltage appearing across the nodes N1 and N2 in the store operation, i.e., the strongly boosted voltage V_{HH} , in accordance with the inverse ratio of each capacitance of the capacitor C_{f} and tunnel capacitor TC. Compared with the constitution of the memory cell shown in the device of Fig. 1, the number of capacitors formed in the non-volatile memory cell portion is decreased from three (C1, C2, C3) to one (C_{f}). Therefore, the value of the power supply voltage V_{HH} necessary for the store operation can be made lower than the voltage VH₀ (25 ∼ 30 V) in the prior device, e.g. the voltage around 18 ∼ 22 V as previously stated. This means that the strength of a cell able to withstand the voltage application need not be so high, and thus the space occupied by the cells on the chip is relatively decreased. Accordingly, it is possible to raise a degree of integration of the circuit.

Next, a concrete circuit constitution and operation of the high voltage generating circuit 3 will be explained with reference to Fig. 5. The circuit of Fig. 5 comprises an internal oscillating circuit 31, a boosting circuit 32, and a voltage control circuit 33, as main constituent elements.

The internal oscillating circuit 31 has a fundamental function of being brought to the enable state in response to the "L" level store signal ST and oscillating (generating) a chain of clocks CLK. Additionally, the circuit 31 stops oscillating the clocks CLK when a potential at a node A reaches a predetermined level. The store signal ST is fed via an inverter 311 to a gate of a transistor 312, which is turned ON in response to the "L" level store signal S̅T̅ and feeds the power supply voltage V_{CC} (5 V) to the boosting circuit 32.

The boosting circuit 32 has a Cockcroft-type constitution including a CR circuit consisting of a transistor 321 as a resistor and a capacitor 322 in N stages (10 ∼ 20 stages). Each of the CR circuits is supplied with the clock output CLK of the internal oscillating circuit 31 at every other stage, or supplied via an inverter 313 with the clock output CLK at every other stage. As a result, the boosting circuit 32 outputs a boosted voltage (20 V) at the node A in response to the power supply voltage V_{CC} and the "L" level store signal ST.

The voltage control circuit 33 includes capacitors 331 and 332 as a voltage dividing means connected between the node A and the power supply line V_{SS} (0 V), and an operational amplifier 333 for comparing and amplifying a voltage at a junction (node B) of the capacitors, which is preset to be 2 V, and a reference voltage V_{ref} (2 V). The circuit 33 feeds the output of the operational amplifier 333 back to the internal oscillating circuit 31 as a signal FV.

Furthermore, an output stage circuit is connected between the node A and an output end, which is composed of a depletion type transistor 341 connected between the node A and the power supply line V_{CC} and responding to the store signal S̅T̅, a depletion type transistor 342 connected between the output end and the power supply line V_{CC} and responding to the store signal S̅T̅, a depletion type transistor 343 connected between the node A and the output end, a depletion type transistor 344 connected between a gate and a drain of the transistor 343, and a capacitor 345 connected between the gate of the transistor 343 and the power supply line V_{SS}. Each threshold voltage of the transistors 341 and 342 is made -3 V or more, and that of the transistors 343 and 344 is made -5 V or less. The output stage circuit has a function of smoothing the rise from 5 V to 20 V in the voltage appearing at the node A, and reducing a time required for switching between the voltage (20 V) in the store operation and the voltage (5 V) in the other operation.

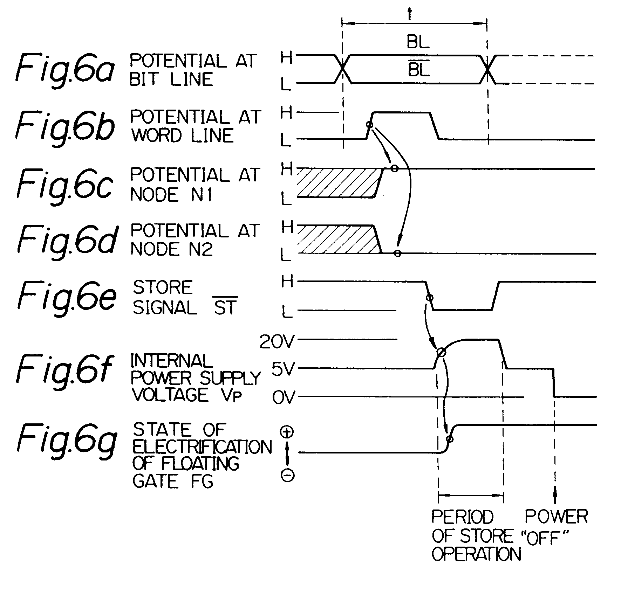

Next, the store and recall operation of the device shown in Fig. 3 will be described with reference to Figs. 6a to 8f.

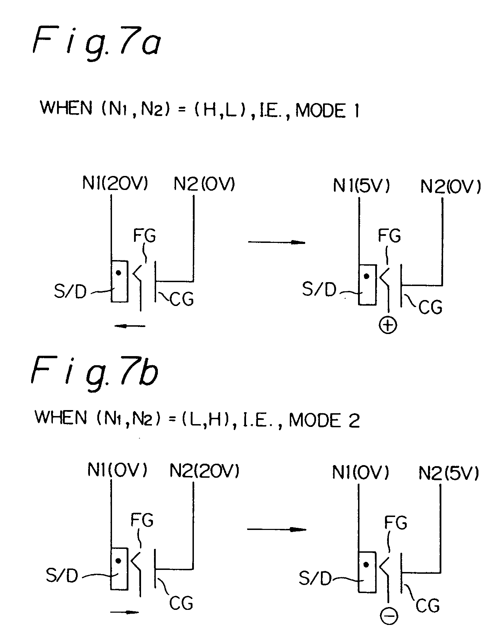

### (1) Store Operation (see Figs. 6a to 6f, and Figs. 7a and 7b)

Assuming that a potential at the word line WL is raised to the "H" level in a time period t in which a potential at the bit line BL is "H" level and a potential at the bit line B̅L̅ is "L" level. In this state, the transistors Q5 and Q6 are turned ON, and accordingly, the node N1 is "H" level and the node N2 is "L" level. Note, the hatched portion in the illustrated drawing indicates an uncertain state of the potential. In this state, when the store signal S̅T̅ is lowered to "L" level, the internal power supply voltage Vₚ is changed from the voltage V_{CC} of 5 V to the voltage V_{HH} of 20 V, and as a result, the voltage of 20 V appears at the node N1 and the voltage of 0 V appears at the node N2.

Namely, the voltage of 20 V is applied across the diffused region S/D and the control gate CG in the polarity as shown in Fig. 7a, and thus electrons are injected by the tunnel effect from the floating gage FG to the node N1 (shown by an arrow mark). Next, when the store signal ST is returned to the "H" level, the movement of electrons ceases, so that the floating gate FG is "positively" electrified. This state corresponds to the state of the memory of the SRAM cell in which the nodes N1 and N2 are "H" level and "L" level, respectively. This state is hereinafter referred to as a mode 1.

Therefore, where the potential at the word line WL is raised to the "H" level in a time period in which a potential at the bit line BL is "L" level and a potential at the bit line B̅L̅ is "H" level, the nodes N1 and N2 are "L" level and "H" level, respectively, although not shown in Figs. 6a to 6g. As a result, the floating gate FG is "negatively" electrified as shown in Fig. 7b. This state is hereinafter referred to as a mode 2.

As stated above, when the power source is turned OFF after the store operation, the content stored in the EEPROM cell when the power source is turned OFF is maintained because the state of electrification of the floating gate FG is not changed (see Figs. 6f and 6g).

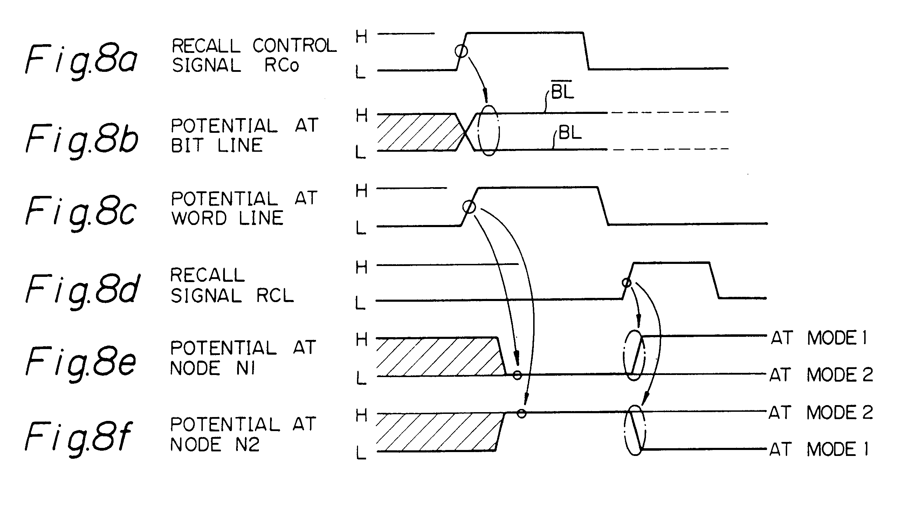

### (2) Recall Operation (see Figs. 8a to 8f)

First, the recall control signal RC₀ is raised to "H" level at a certain time and the potentials at all of the word lines WL are raised to "H" level. In this state, the potential at the bit line BL is pulled down to "L" level by turning ON the transistor 43 (see Fig. 3), and the potential at the bit line B̅L̅ is pulled up to "H" level by the transistor 42. Since the transistors Q5 and Q6 are in the ON state, the node N1 settles to the "L" level and the node N2 settles to the "H" level. At this time, the SRAM cell is preset. When the recall signal RCL is then raised to "H" level, the recall transistor QR can be made ON.

In the state where " positive" charges are accumulated in the floating gate FG as shown in Fig. 7a, i.e., in the mode 1, the memory transistor QM is made ON, and accordingly, the potential at the source of the transistor QR is pulled down to the potential of V_{SS} (0 V). When the transistor QR is turned ON, the potential at the node N2 is pulled down to "L" level, and when the node N2 is at "L" level, the transistor Q3 is turned ON, and accordingly, the potential at the node N1 is pulled up to "H" level.

Conversely, where "negative" charges are accumulated in the floating gate FG as shown in Fig. 7b, i.e., in the mode 2, the memory transistor QM is made OFF, and accordingly, the potential at the node N2 is maintained at the "H" level and the potential at the node N1 is maintained at the "L" level.

Namely, the state of the memory corresponding to the data stored into the EEPROM cell from the SRAM cell before the power source is turned OFF is recalled to the nodes N1 and N2 in the SRAM cell.

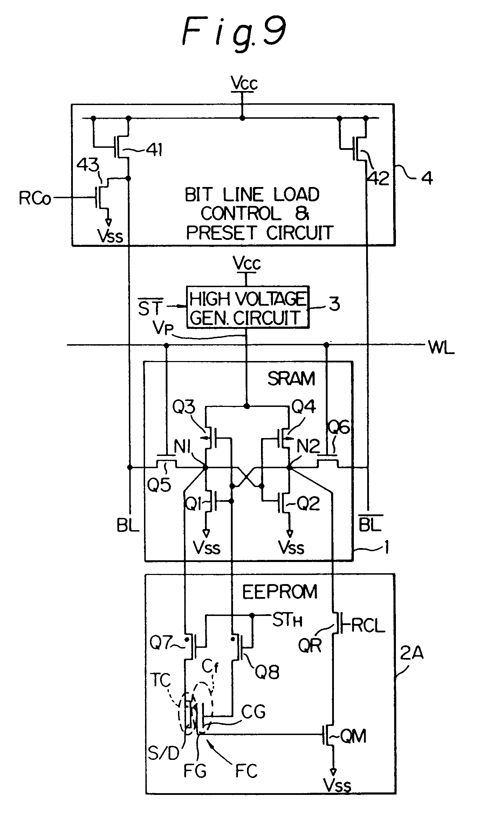

Figure 9 illustrates a circuit constitution of a modification of the embodiment shown in Fig. 3.

The differences between the present embodiment and the embodiment of Fig. 3 are as follows: First, a depletion type transistor Q7 is connected between the node N1 in the SRAM cell portion 1 and the diffused region S/D in an EEPROM cell portion 2A; second, a depletion type transistor Q8 is connected between the node N2 in the SRAM cell portion and the control gate CG in the EEPROM cell portion; and third, a control voltage ST_{H} having a voltage of V_{HH} (18 ∼ 22 V) when the store signal S̅T̅ is "L" level is applied to each gate of the transistors Q7 and Q8.

Since the remaining constitution is the same as in the embodiment of Fig. 3, an explanation thereof will be omitted.

The feature of the operation of the embodiment of Fig. 9 is that, except when the store operation is carried out, the SRAM cell side and EEPROM cell side are electrically separated by the transistors Q7 and Q8. The separation is carried out for the following reason. Namely, where a constant voltage (normally 5 V) is fed as the power supply voltage V_{CC} , a deterioration occurs in the possible number of times that the re-programming can be repeated or in a data storing period. Accordingly, for example, the high voltage generating circuit as shown in Fig. 5 is employed and, a value of the power supply voltage V_{CC} is changed to a voltage exceeding 5 V. In this case, taking the withstand strength of the cell against the voltage application into consideration, preferably the voltage fed to the cell is as low as possible except when the store operation is carried out. More preferably, the voltage is 0 V. The above electrical separation is carried out for the above reason.

Although, in the example illustrated in Fig. 9, the depletion type transistors Q7 and Q8 are employed in the non-volatile memory cell portion 2A, the conventional enhancement type transistors can be substituted therefor.

Also, although, in the disclosed and illustrated embodiments a flip-flop having a CMOS arrangement is employed in the volatile memory cell portion 1, a flip-flop having a NMOS arrangement can be substituted therefor.

## Claims

1. A semiconductor memory device including a memory cell array having a memory cell at each intersection between a plurality of word lines (WL) and bit lines (BL, B̅L̅), the memory cell including:-
a volatile memory cell portion (1) having a flip-flop arrangement (Q1 to Q4) and carrying out a read/write operation of data between a pair of nodes (N1, N2) and a pair of bit lines (BL, B̅L̅); wherein, when a predetermined high voltage (V_{HH}) higher than a normal power voltage (V_{CC}) is applied to the flip-flop arrangement, a difference voltage appearing between the pair of nodes (N1, N2) substantially becomes the high voltage (V_{HH});
and a non-volatile memory cell portion (2, 2A) provided for the volatile memory cell portion (1) on a one-to-one basis, including a memory transistor (QM) having a floating gate (FG), and a capacitor circuit (FC) operatively connected between the pair of nodes (N1, N2) in the volatile memory cell portion (1), the capacitor circuit (FC) having a capacitor (Cf) and a tunnel capacitor (TC) connected to said floating gate (FG), said tunnel capacitor undergoing a tunnel effect when said high voltage (V_{HH}) is applied;
wherein based on the application of the high voltage (V_{HH}) or a control signal (RCL), a storing operation of storing data from the volatile memory cell portion (1) to the non-volatile memory cell portion (2, 2A) or a recall operation of recalling the data from the non-volatile memory cell (2, 2A) portion to the volatile memory cell portion (1) is carried out;
characterised in that, in the non-volatile memory cell portion, the floating gate (FG) of the memory transistor (QM) is interposed between the capacitor (Cf) and tunnel capacitor (TC), and a switching transistor (QR) is connected between the memory transistor (QM) and one (N2) of the pair of nodes and is turned ON in response to said control signal (RCL) in said recall operation,
and in that a bit line load control circuit (4) is operatively connected to one (BL) of the pair of bit lines corresponding to the other (N1) of the pair of nodes and operable to forcibly lower the potential of said bit line (BL) in said recall operation.

2. A device as set forth in claim 1, wherein said non-volatile memory cell portion (2A) further comprises a first transistor (Q7) connected between one (N1) of said pair of nodes (N1, N2) and one end of said capacitor circuit (FC) and a second transistor (Q8) connected between the other (N2) of said pair of nodes and the other end of said capacitor circuit (FC), said first and second transistors (Q7, Q8) being turned ON only when data is transferred to said non-volatile memory cell portion from said volatile memory cell portion (1).

3. A device as set forth in claim 1 or 2, wherein said capacitor circuit (FC) is formed by a structure including a diffused region (S/D) formed in a semiconductor substrate (5), said floating gate (FG) formed via a tunnel insulation layer (6) on said diffused region, and a control gate (CG) formed via an insulation layer (9) on said floating gate.

4. A device as set forth in claim 3, wherein in said capacitor circuit (FC), said tunnel capacitor (TC) is equivalently formed between said diffused region and said floating gate, and said capacitor (C_{f}) is equivalently formed between said floating gate and said control gate.

5. A device as set forth in claim 4, wherein a thickness of said tunnel insulation layer (6) is made approximately 10 nm and a thickness of said insulation layer (9) between said floating gate (FG) and said control gate (CG) is made approximately 50 to 60 nm, whereby a greater part of said difference voltage between said pair of nodes (N1, N2) in said store operation is applied across said tunnel capacitor (TC).

6. A device as set forth in claim 2, or claim 3, 4 or 5 as appended thereto, wherein said first and second transistors (Q7, Q8) are depletion-type metal oxide semiconductor transistors turned ON in response to a control voltage (ST_{H}) of said high voltage (V_{HH}).

7. A device as set forth in claim 2, or claim 3, 4 or 5 as appended thereto, wherein said first and second transistors (Q7, Q8) are enhancement-type metal oxide semiconductor transistors turned ON when said store operation is carried out.

8. A device as set forth in any preceding claim, wherein a value of said high voltage (V_{HH}) is 18 to 22 V and a value of said normal power voltage (V_{CC}) is 5 V.

9. A device as set forth in any preceding claim, wherein said flip-flop is composed of four transistors (Q1 to Q4) having a complementary metal oxide semiconductor structure.

10. A device as set forth in any one of claims 1 to 8, wherein said flip-flop is composed of four transistors having an N-channel-type metal oxide semiconductor structure.

## Patentansprüche

1. Halbleiterspeichereinrichtung, die eine Anordnung von Speicherzellen einschließt, welche an jedem Schnittpunkt zwischen einer Vielzahl von Wort-Leitungen (WL) und Bit-Leitungen (BL, B̅L̅) eine Speicherzelle aufweist, wobei die Speicherzelle umfaßt:
ein nicht-permanentes Speicherzellenteil (1) mit einer Flip-Flop-Anordnung (Q1 bis Q4), das eine Schreib-/Lese-Datenoperation zwischen einem Knotenpaar (N1, N2) und einem Bit-Leitungspaar (BL, B̅L̅) ausführt; wobei eine zwischen dem Knotenpaar (N1, N2) auftretende Differenzspannung im wesentlichen gleich der hohen Spannung (V_{HH}) ist, wenn eine vorbestimmte hohe Spannung (V_{HH}), die höher ist als die übliche Versorgungsspannung (V_{CC}), an die Flip-Flop-Anordnung angelegt ist;
und ein permanentes Speicherzellenteil (2, 2A), das im Verhältnis 1:1 zum nicht-permanenten Speicherzellenteil (1) vorliegt, beinhaltend einen Speichertransistor (QM) mit einem Floating-Gate (FG), und einen zwischen dem Knotenpaar (N1, N2) im nicht-permanenten Speicherzellenteil wirksam angeschlossenen kapazitiven Schaltkreis (FC), wobei der kapazitive Schaltkreis (FC) einen Kondensator (Cf) und einen mit dem Floating-Gate (FG) verbundenen Tunnelkondensator (TC) enthält und der Tunnelkondensator einen Tunneleffekt erfährt, wenn die hohe Spannung (V_{HH}) angelegt ist;
worin bei Anlegen der hohen Spannung (V_{HH}) oder eines Steuersignals (RCL) eine Speicheroperation durchgeführt wird, bei der Speicherdaten vom nichtpermanenten Speicherzellenteil (1) im permanenten Speicherzellenteil (2, 2A) gespeichert werden, oder eine Rückrufoperation, bei der Daten aus dem permanenten Speicherzellenteil (2, 2A) in den nicht-permanenten Speicherzellenteil (1) zurückgerufen werden;
dadurch gekennzeichnet, daß im permanenten Speicherzellenteil das Floating-Gate (FG) des Speichertransistors (QM) zwischen dem Kondensator (Cf) und dem Tunnelkondensator (TC) geschaltet ist und ein Umschalttransistor (QR) zwischen dem Speichertransistor (QM) und einem Knoten (N2) des Knotenpaars angeschlossen ist und auf das Steuersignal (RCL) hin bei der Aufrufoperation auf ON geschaltet wird,
und daß ein Bit-Leitungslast-Kontrollschaltkreis (4) mit derjenigen Leitung (BL) des Bit-Leitungspaars wirksam verbunden ist, die dem anderen Knoten (N1) des Knotenpaars entspricht, und dazu dient, das Potential der Bit-Leitung (BL) im Zuge der Aufrufoperation zwangsweise zu vermindern.

2. Vorrichtung nach Anspruch 1, worin der permanente Speicherzellenteil (2A) weiter einen ersten Transistor (Q7) umfaßt, der mit einem Knoten (N1) des Knotenpaars (N1, N2) und einem Anschluß des kapazitiven Schaltkreises (FC) verbunden ist, und einen zweiten Transistor (Q8), der mit dem anderen Knoten (N2) des Knotenpaars und dem anderen Anschluß des kapazitiven Schaltkreises (FC) verbunden ist, wobei dieser erste und zweite Transistor (Q7, Q8) nur dann auf ON geschaltet werden, wenn aus dem nicht-permanenten Speicherzellenteil (1) Daten zu dem permanenten Speicherzellenteil übertragen werden.

3. Vorrichtung nach Anspruch 1 oder 2, worin der kapazitive Schaltkreis (FC) aus einer Struktur aufgebaut ist, die einen in einem Halbleitersubstrat (5) gebildeten Diffusionsbereich (S/D), das per Tunnelzwischenschicht (6) auf dem Diffusionsbereich gebildete Floating-Gate (FG), und ein per Zwischenschicht (9) auf dem Floating-Gate gebildetes Steuer-Gatter (CG) einschließt.

4. Vorrichtung nach Anspruch 3, worin in dem kapazitiven Schaltkreis (FC) der Tunnelkondensator (TC) gleichermaßen zwischen dem Diffusionsbereich und dem Floating-Gate, und der Kondensator (Cf) gleichermaßen zwischen dem Floating-Gate und dem Steuer-Gatter gebildet wird.

5. Vorrichtung nach Anspruch 4, wobei die Dicke einer Tunnelzwischenschicht (6) ungefähr 10 nm und die Dicke der Isolationsschicht (9) zwischen dem Floating-Gate (FG) und dem Steuer-Gatter (CG) etwa 50-60 nm beträgt, so daß bei der Speicheroperation der größere Teil der Spannungsdifferenz zwischen den Knoten des Paars (N1, N2) am Tunnelkondensator (TC) anliegt.

6. Vorrichtung nach Anspruch 2 oder den sich darauf beziehenden Ansprüchen 3, 4 oder 5, wobei der erste und der zweite Transistor (Q7, Q8) Verarmungs-Metalloxid-Halbleitertransistoren sind, die bei Anlegen einer Steuerspannung (ST_{H}) der hohen Spannung (V_{HH}) auf ON schalten.

7. Vorrichtung nach Anspruch 2 oder den sich darauf beziehenden Ansprüchen 3, 4 oder 5, wobei der erste und der zweite Transistor (Q7, Q8) Anreicherungs-Metalloxid-Halbleitertransistoren sind, die beim Ausführen der Speicheroperation auf ON schalten.

8. Vorrichtung nach irgend einem vorgehenden Anspruch, wobei der Wert der hohen Spannung (V_{HH}) 18 bis 22 V ist, und der Wert der normalen Versorgungsspannung (V_{CC}) 5 V beträgt.

9. Vorrichtung nach irgend einem vorgehenden Anspruch, wobei der Flip-Flop aus vier Transistoren (Q1 bis Q4) mit einer Komplementär-Metalloxid-Halbleiterstruktur besteht.

10. Vorrichtung nach irgend einem der Ansprüche 1 bis 8, wobei der Flip-Flop aus vier Transistoren mit N-Kanal-Metalloxid-Halbleiterstruktur besteht.

## Revendications

1. Dispositif de mémoire à semiconducteur incluant un réseau de cellules de mémoire comportant une cellule de mémoire au niveau de chaque intersection entre une pluralité de lignes de mot (WL) et de lignes de bit (BL, B̅L̅), la cellule de mémoire incluant :
une partie de cellule de mémoire volatile (1) comportant un agencement de bascules (Q1 à Q4) et mettant en oeuvre une opération de lecture/écriture de données entre une paire de noeuds (N1, N2) et une paire de lignes de bit (BL, B̅L̅) ; dans lequel, lorsqu'une tension élevée prédéterminée (V_{HH}) supérieure à une tension d'alimentation normale (V_{CC}) est appliquée à l'agencement de bascules, une différence de tension qui apparaît entre la paire de noeuds (N1, N2) devient sensiblement la tension élevée (V_{HH}) ; et
une partie de cellule de mémoire non volatile (2, 2A) prévue pour la partie de cellule de mémoire volatile (1) sur une base biunivoque, incluant un transistor de mémoire (QM) comportant une grille flottante (FG), et un circuit de capacité (FC) connecté de façon opérationnelle entre la paire de noeuds (N1, N2) contenus dans la partie de cellule de mémoire volatile (1), le circuit de capacité (FC) comportant une capacité (Cf) et une capacité tunnel (TC) connectées à ladite grille flottante (FG), ladite capacité tunnel subissant un effet tunnel lorsque ladite tension élevée (V_{HH}) est appliquée ;
dans lequel, sur la base de l'application de la tension élevée (V_{HH}) ou d'un signal de commande (RCL), une opération de stockage consistant à stocker des données en provenance de la partie de cellule de mémoire volatile (1) dans la partie de cellule de mémoire non volatile (2, 2A) ou une opération de rappel consistant à rappeler les données contenues dans la partie de cellule de mémoire non volatile (2, 2A) pour les stocker dans la partie de cellule de mémoire volatile (1) est mise en oeuvre,
caractérisé en ce que, dans la partie de cellule de mémoire non volatile, la grille flottante (FG) du transistor de mémoire (QM) est interposée entre la capacité (Cf) et la capacité tunnel (TC) et un transistor de commutation (QR) est connecté entre le transistor de mémoire (QM) et l'un (N2) de la paire de noeuds et est rendu passant en réponse audit signal de commande (RCL) lors de ladite opération de rappel ; et
en ce qu'un circuit de commande de charge de ligne de bit (4) est connecté de façon opérationnelle à l'une (BL) de la paire de lignes de bit correspondant à l'autre (N1) de la paire de noeuds et peut fonctionner pour abaisser de manière forcée le potentiel de ladite ligne de bit (BL) lors de ladite opération de rappel.

2. Dispositif selon la revendication 1, dans lequel ladite partie de cellule de mémoire non volatile (2A) comprend en outre un premier transistor (Q7) connecté entre l'un (N1) de ladite paire de noeuds (N1, N2) et une extrémité dudit circuit de capacité (FC) et un second transistor (Q8) connecté entre l'autre (N2) de ladite paire de noeuds et l'autre extrémité dudit circuit de capacité (FC), lesdits premier et second transistors (Q7, Q8) étant rendus passants seulement lorsque des données sont transférées dans ladite partie de cellule de mémoire non volatile depuis ladite partie de cellule de mémoire volatile (1).

3. Dispositif selon la revendication 1 ou 2, dans lequel ledit circuit de capacité (FC) est formé par une structure incluant une région diffusée (S/D) formée dans un substrat semiconducteur (5), ladite grille flottante (FG) formée via une couche d'isolation tunnel (6) sur ladite région diffusée et une grille de commande (CG) formée via une couche d'isolation (9) par ladite grille flottante.

4. Dispositif selon la revendication 3, dans lequel, dans ledit circuit de capacité (FC), ladite capacité tunnel (TC) est formée de façon équivalente entre ladite région diffusée et ladite grille flottante et ladite capacité (Cf) est formée de façon équivalente entre ladite grille flottante et ladite grille de commande.

5. Dispositif selon la revendication 4, dans lequel une épaisseur de ladite couche d'isolation tunnel (6) est rendue approximativement égale à 10 nm et une épaisseur de ladite couche d'isolation (9) entre ladite grille flottante (FG) et ladite grille de commande (CG) est rendue approximativement égale à 50 à 60 nm et ainsi, une partie plus importante de ladite tension de référence entre ladite paire de noeuds (N1, N2) lors de ladite opération de stockage est appliquée aux bornes de ladite capacité tunnel (TC).

6. Dispositif selon la revendication 2 ou selon la revendication 3, 4 ou 5, dans lequel lesdits premier et second transistors (Q7, Q8) sont des transistors métal-oxyde-semiconducteur du type à appauvrissement rendus passants en réponse à une tension de commande (ST_{H}) de ladite tension élevée (V_{HH}).

7. Dispositif selon la revendication 2 ou selon la revendication 3, 4 ou 5, dans lequel lesdits premier et second transistors (Q7, Q8) sont des transistors métal-oxyde-semiconducteur du type à enrichissement rendus passants lorsque ladite opération de stockage est mise en oeuvre.

8. Dispositif selon l'une quelconque des revendications précédentes, dans lequel une valeur de ladite tension élevée (V_{HH}) est comprise entre 18 et 22 V et une valeur de ladite tension d'alimentation normale (V_{CC}) vaut 5 V.

9. Dispositif selon l'une quelconque des revendications précédentes, dans lequel ladite bascule est constituée par quatre transistors (Q1 à Q4) présentant une structure métal-oxyde-semiconducteur complémentaires.

10. Dispositif selon l'une quelconque des revendications 1 à 8, dans lequel ladite bascule est constituée par quatre transistors présentant une structure métal-oxyde-semiconducteur du type à canal N.
